# EUROPEAN PATENT SPECIFICATION

(11) **EP 4 546 435 B1**
(45) Date of publication and mention of the grant of the patent: **28.10.2026**
(21) Application number: 23851192.7
(22) Date of filing: 22.02.2023
(51) Int. Cl.: H10F 71/10, H10F 10/166, H10F 71/00, H10F 77/20

(54) **TCO COATING METHOD, TCO COATING DEVICE, AND SOLAR CELL AND PREPARATION METHOD THEREFOR**
TCO-BESCHICHTUNGSVERFAHREN, TCO-BESCHICHTUNGSVORRICHTUNG SOWIE SOLARZELLE UND HERSTELLUNGSVERFAHREN DAFÜR
PROCÉDÉ DE REVÊTEMENT DE TCO, DISPOSITIF DE REVÊTEMENT DE TCO ET CELLULE SOLAIRE ET SON PROCÉDÉ DE PRÉPARATION

(30) Priority: 09.08.2022 CN 202210950302
(43) Date of publication of application: 30.04.2025
(73) Proprietor: Tongwei Solar (Chengdu) Co., Ltd., Chengdu, Sichuan 610299 (CN)
(72) Inventor: SHI, Jianhua, Chengdu, Sichuan 610299 (CN); ZHANG, Haichuan, Chengdu, Sichuan 610299 (CN); YUAN, Qiang, Chengdu, Sichuan 610299 (CN); MENG, Chuncai, Chengdu, Sichuan 610299 (CN); FU, Haoxin, Chengdu, Sichuan 610299 (CN); MENG, Fanying, Chengdu, Sichuan 610299 (CN); DU, Junlin, Chengdu, Sichuan 610299 (CN); LIU, Zhengxin, Chengdu, Sichuan 610299 (CN); ZHOU, Hua, Chengdu, Sichuan 610299 (CN)
(74) Representative: Gill Jennings & Every LLP
(86) International application number: PCT/CN2023/077674
(87) International publication number: WO 2024/031956

(56) References cited:
- CN-A- 102 304 695
- CN-A- 106 637 126
- CN-A- 111 081 826
- CN-A- 111 403 562
- CN-A- 112 359 332
- CN-A- 114 823 990
- CN-A- 114 823 990
- CN-A- 115 274 935
- CN-U- 202 865 329
- CN-U- 209 260 195
- CN-U- 216 738 513
- CN-U- 216 738 513
- JP-A- H1 081 956

## Description

### TECHNICAL FIELD

The present application relates to the technical field of cells, in particular to a transparent conductive oxide (TCO) coating method, a TCO coating apparatus, a solar cell and a preparation method thereof.

### BACKGROUND

Heterojunction (HJT) solar cell (referred to as a heterojunction cell), a heterojunction back-contact (HBC) cell (referred to as an interdigital back-contact heterojunction solar cell), and a stacked solar cell are all high-efficiency solar cells. For example, the HJT solar cell has a low temperature coefficient, low light-induced attenuation, and high stability. The preparation method of the HJT solar cell typically involves: taking n-type monocrystalline silicon wafer as a substrate; subjecting the substrate to surface texturing and chemical cleaning such that the surface of the substrate forms a pyramidal concave-convex structure with improved light absorption; subjecting the textured surface to chemical cleaning again to form a clean surface, and depositing intrinsic amorphous silicon films on both surfaces of the cleaned silicon wafer by a plasma enhanced chemical vapor deposition (PECVD) or other method; depositing a P-type doped amorphous silicon film on one surface, and depositing an N-type doped amorphous silicon film on the other surface; depositing transparent conductive oxide films on both surfaces by a TCO coating process; and forming metal electrodes by a screen printing, electroplating or inkjet printing technology, thus obtaining the HJT heterojunction cell with a symmetrical structure.

The TCO film serves as an important functional layer film connecting the upper and the lower layers, and plays several important roles: 1. The TCO film functions surface anti-reflection, i.e., it forms a good anti-reflection coating layer (AR-coating) on the silicon surface to reduce the reflection loss of light on the cell's surface. 2. The TCO film functions carrier collection and transport, i.e., it is in good contact with the amorphous film to effectively collect photogenerated carriers separated into the amorphous silicon film and transport the same to the metal electrodes. 3. The TCO film functions surface protection, i.e., it completely covers the amorphous silicon film to block the influence of the external environment on the amorphous silicon passivation film. Similarly, some HBC cells or stacked solar cells also contain TCO film and play an important role.

However, with respect to the conventional TCO coating technologies, water vapor remains at the contact interface between the amorphous silicon film and the TCO film during the continuous production, resulting in a significant fluctuation and large dispersion in the conversion efficiency of the produced cell, and an uneven and unstable performance of the cell produced in large-scale production. Therefore, the conventional technologies still have room for improvement.

CN 216738513 U discloses an auxiliary device for a PVD (Polymerization and Deposition) equipment, characterized in that it comprises:
an evacuation assistance device, disposed between the feed chamber and the heating chamber of the PVD equipment, which is activated when the pressure in the feed chamber reaches a preset pressure threshold;
a monitoring device, disposed in the heating chamber, which detects moisture in the heating chamber and uploads the detected real-time data.

### SUMMARY

The present invention provides a TCO coating method, a TCO coating apparatus, and a preparation method of a heterojunction cell.

The present invention is realized by the following solutions.

One aspect of the present invention provides a TCO coating method, including steps of:
loading a workpiece to be coated onto a carrier plate, and performing TCO coating process on the workpiece to be coated;
detecting a water vapor partial pressure during the TCO coating process; and
stopping the TCO coating process or continuing to complete the TCO coating process when the water vapor partial pressure during the TCO coating process is detected to be greater than 5.0×e⁻³ Pa, and then performing ion etching cleaning on the carrier plate to enable the water vapor partial pressure to be no greater than 5.0×e⁻³ Pa.

In some embodiments, the ion etching cleaning is performed for 5 min to 15 min.

In some embodiments, the ion etching cleaning is performed at a pressure ranging from 0.3 Pa to 1.3 Pa.

In some embodiments, an ion source used in the ion etching cleaning is at least one selected from the group consisting of halogen, halogenated compound gas, nitrogen gas, and inert gas.

In some embodiments, the ion source used in the ion etching cleaning includes at least one of halogen and halogenated compound gas, and at least one of nitrogen gas and inert gas.

In some embodiments, a transparent conductive material used during the TCO coating process is at least one selected from the group consisting of a transparent conductive metal, a transparent conductive compound, and a transparent conductive polymer.

In some embodiments, the workpiece to be coated includes a monocrystalline silicon wafer and an amorphous silicon film loaded on a surface of the monocrystalline silicon wafer.

In some embodiments, the amorphous silicon film includes an intrinsic amorphous silicon film and a p-type doped amorphous silicon film that are stacked in sequence.

In some embodiments, the amorphous silicon film includes an intrinsic amorphous silicon film and an n-type doped amorphous silicon film that are stacked in sequence.

Another aspect of the present invention provides a TCO coating apparatus for forming a transparent conductive film according to the TCO coating method as described above, including:
a carrier plate configured to load a workpiece to be coated;
a first buffer chamber, a first coating chamber, and a second buffer chamber that are arranged in sequence, wherein a TCO coating source is provided in the first coating chamber and configured to perform TCO coating process on the workpiece to be coated on the carrier plate;
a water vapor partial pressure detecting device configured to detect a water vapor partial pressure in the first coating chamber during the TCO coating process; and
at least one plasma-etching cleaning device provided in at least one of the first buffer chamber and the second buffer chamber, when the water vapor partial pressure detected by the water vapor partial pressure detecting device is greater than 5.0×e⁻³ Pa, the at least one plasma-etching cleaning device is configured to perform ion etching cleaning on the carrier plate to enable the water vapor partial pressure in the first coating chamber to be no greater than 5.0×e⁻³ Pa.

In some embodiments, the TCO coating apparatus further includes a second coating chamber and an isolation chamber, the second coating chamber is provided between the first coating chamber and the second buffer chamber, and the isolation chamber is provided between the first coating chamber and the second coating chamber;
wherein an upper portion of one of the first coating chamber and the second coating chamber is provided with the TCO coating source, and a lower portion of the other one of the first coating chamber and the second coating chamber is provided with the TCO coating source, such that the TCO coating process is performed on both surfaces of the workpiece to be coated, respectively;
wherein two water vapor partial pressure detecting devices are provided, and the two water vapor partial pressure detecting devices are configured to detect the water vapor partial pressure in the first coating chamber and the second coating chamber during the TCO coating process, respectively;
wherein the plasma-etching cleaning device is provided in at least one of the first buffer chamber, the isolation chamber, and the second buffer chamber, and the plasma-etching cleaning device is configured to perform the ion etching cleaning on the carrier plate to enable the water vapor partial pressure in the first coating chamber and the second coating chamber to be no greater than 5.0×e⁻³ Pa when the water vapor partial pressure detected by the water vapor partial pressure detecting device is greater than 5.0×e⁻³ Pa.

In some embodiments, two plasma-etching cleaning devices are provided, one plasma-etching cleaning device is located at the upper portion of any one of the first buffer chamber, the isolation chamber, and the second buffer chamber, and another plasma-etching cleaning device is located at the lower portion of any one of the first buffer chamber, the isolation chamber, and the second buffer chamber, such that the ion etching cleaning is performed on upper and lower surfaces of the carrier plate.

In some embodiments, the TCO coating apparatus further includes a feed chamber and a discharge chamber, the feed chamber is provided upstream of the first buffer chamber for feeding, and the discharge chamber is provided downstream of the second buffer chamber for discharging.

In some embodiments, the plasma-etching cleaning device is selected from the group consisting of an electron cyclotron reactor, an inductive coupler, a capacitive coupler, a dual plasma source reactor, a magnetic enhanced reaction ion etching reactor, or a combination thereof.

In some embodiments, the water vapor partial pressure detecting device is selected from the group consisting of a residual gas analyzer, a spectrometer, or a combination thereof.

Yet another aspect of the present invention provides a method for preparing a solar cell, including steps of:
subjecting a monocrystalline silicon wafer to surface texturing and chemical cleaning process to obtain a textured monocrystalline silicon wafer; and
forming an amorphous silicon film on a surface of the textured monocrystalline silicon wafer, then forming a transparent conductive film, and finally preparing an electrode to obtain a solar cell;
wherein the step of forming the transparent conductive film is performed according to the TCO coating method as described above or using the TCO coating apparatus as described above.

In some embodiments, the step of forming the amorphous silicon film includes a step of:
forming intrinsic amorphous silicon films on upper and lower surfaces of the textured monocrystalline silicon wafer respectively, and then forming a p-type doped amorphous silicon film and a n-type doped amorphous silicon film on the upper and lower surfaces respectively.

In some embodiments, the step of preparing the electrode includes steps of:
screen printing a silver paste on surfaces of the transparent conductive film, and then sintering at 170 °C to 200 °C.

Details of one or more embodiments of the present application are set forth in the accompanying drawings and description below. Other features, objects, and advantages of the present application will become apparent from the description, drawings, and claims.

### BRIEF DESCRIPTION OF THE DRAWINGS

In order to better describe and illustrate embodiments and/or examples of the present application disclosed herein, reference may be made to one or more accompanying drawings. Additional details or examples used to describe the accompanying drawings should not be considered as limitations on the scope of any of the disclosed contents, the presently described embodiments and/or examples, and the presently understood best mode of the present application.
FIG. 1 is a schematic structural view of a TCO coating apparatus according to an embodiment of the present application.
FIG. 2 is a schematic structural view of a heterojunction cell according to an embodiment of the present application.
FIG. 3 show a comparative diagram of the efficiency distribution of the heterojunction cells prepared in Example 4 and Example 5.

### Reference signs:

1: TCO coating apparatus; 10: carrier plate; 11: first buffer chamber; 111: first buffer sub-chamber; 12: first coating chamber; 13: second buffer chamber; 131: second buffer sub-chamber; 14: water vapor partial pressure detecting device; 15: plasma-etching cleaning device; 16: second coating chamber; 17: isolation chamber; 18: feed chamber; 19: discharge chamber; 20: TCO coating source;
100: heterojunction cell; 110: crystalline silicon wafer; 120: intrinsic amorphous silicon film; 130: p-type doped amorphous silicon film; 140: n-type doped amorphous silicon film; 150: transparent conductive film; 160: metal electrode.

In order to better describe and illustrate embodiments and/or examples of the present application disclosed herein, reference may be made to one or more accompanying drawings. Additional details or examples used to describe the accompanying drawings should not be considered as limitations on the scope of any of the disclosed contents, the presently described embodiments and/or examples, and the presently understood best mode of the present application.

### DETAILED DESCRIPTION

For easy understanding of the present application, a more comprehensive description of the present application is given below with reference to the accompanying drawings. Preferred embodiments of the present application are illustrated in the accompanying drawings. However, the present application may be implemented in many different forms and is not limited to the embodiments described herein. Rather, these embodiments are provided to make the contents disclosed in the present application more thoroughly and comprehensive.

In addition, the terms "first" and "second" are used for descriptive purposes only, and cannot be construed as indicating or implying a relative importance, or implicitly specifying the number or the sequence of the indicated technical features. Thus, the feature defined with "first" or "second" may explicitly or implicitly include one or more features. In the description of the present application, "a plurality of" means two or more, such as two or three, unless otherwise defined explicitly and specifically.

Unless defined otherwise, all technical and scientific terms used herein have the same meaning as commonly understood by those skilled in the art of the present application. The terms used in the specification of the present application are for the purpose of describing exemplary examples only and are not intended to limit the present application.

As described in the background, with respect to the conventional TCO coating technologies, the water vapor remains at the contact interface between the amorphous silicon film and the TCO film. Moreover, during a continuous production, the water vapor in the coating apparatus is difficult to be controlled and fluctuates frequently, and thus the amount of the residual water vapor during the TCO coating process is difficult to be controlled. However, the residual water vapor may seriously affect the surface energy at the amorphous silicon/TCO contact interface, the composition of the surface chemical bonds, and the microstructure of TCO film, resulting in a high contact resistance and an uncontrolled effective work function at the amorphous silicon/TCO contact interface, so that the fill factor (FF) of the cell is low, and the conversion efficiency of the cell is low, and exhibits significant fluctuation and large dispersion, which seriously affects the production efficiency of HJT cells in large-scale production.

Many methods have been tried to remove water in the conventional technologies, for example, by adding a cold trap (standard configuration of general apparatus), a condensate pump or the like at the end of TCO coating apparatus. These methods can effectively alleviate the negative impact of the water vapor on the HJT cells to a certain extent in the large-scale production. However, during the continuous production, the water vapor typically increases rapidly and then becomes saturated within a certain cycle, and this cycle is unpredictable and difficult to be controlled, which still affects the stability of the large-scale production and increases the cost.

The conventional continuous TCO coating methods generally focus on impurity removal or water removal of the coating chamber before and after the TCO coating. However, it is found by the technicians of the present application in a long-term cell production process that: during the continuous coating process of silicon wafers, the water vapor on the carrier plate loaded with silicon wafers is an important factor leading to a difficulty in precisely controlling the water vapor in the continuous coating production. It is also found by the technicians of the present application that film materials may deposit on the carrier plate loaded with silicon wafers, and then absorb water vapor, and the carrier plate is generally reused, even if water is strictly controlled before coating, the water vapor accumulated on the carrier plate may still be transferred to the coated silicon wafer or the coating chamber during continuous coating. Moreover, the residual water can be dissociated into oxygen ions (O⁰, O⁻¹, and O⁻²) and hydroxyl ions (OH⁻), and the OH⁻ ions can undergo substitutions with weak bonds (Si-Si, Si-H, Si-H2, Si-H3) on the surface of the amorphous film, changing the chemical bond states at the interface, affecting the effective work function matching of the amorphous silicon/TCO interface, increasing the contact resistance at the amorphous silicon/TCO interface. Meanwhile, the OH⁻ions can affect the microstructure state of the TCO film, and suppress the crystallization rate and the ionization rate of the TCO film during the production. Therefore, in the conventional continuous production process, water vapor always increases rapidly within a period of time, thereby resulting in significant fluctuation and large dispersion in the conversion efficiency of the prepared heterojunction cell.

On the basis of the above research findings, a TCO coating method and a TCO coating apparatus are obtained by the technicians of the present application after various creative experimentation and exploration, which can reduce the amount of the residual water vapor on the silicon wafer during continuous production, have excellent performance and high production stability.

An embodiment of the present application provides a TCO coating method including step S10.

S10, a workpiece to be coated is loaded onto a carrier plate, and TCO coating process is performed on the workpiece to be coated.

During the TCO coating process, a water vapor partial pressure is detected.

When the water vapor partial pressure during the TCO coating process is detected to be greater than 5.0×e⁻³ Pa, the TCO coating process is stopped or continue to complete the TCO coating process, and then ion etching cleaning is performed on the carrier plate to enable the water vapor partial pressure to be no greater than 5.0×e⁻³ Pa.

In the above-described TCO coating method, the workpiece to be coated is loaded onto the carrier plate, and TCO coating process is performed on the workpiece to be coated. A water vapor partial pressure during the TCO coating process is detected, and when the water vapor partial pressure during the TCO coating process is detected to be greater than 5.0×e⁻³ Pa, the TCO coating process is stopped and the ion etching cleaning is then performed on the carrier plate, or the TCO coating process continues until it is completed, and the ion etching cleaning is then performed on the carrier plate, so as to etch away the residue and the adsorbed moisture on the carrier plate, so that the water vapor pressure is no greater than 5.0×e⁻³ Pa. By detecting the water vapor partial pressure in the environment during the coating process, and by cleaning the residue and the adsorbed moisture on the carrier plate through etching, the water vapor partial pressure in the coating process can be controlled within a specific range, effectively cutting off the source of water vapor fluctuation from the origin, and reducing the residual water vapor on the TCO-coated workpiece. As a result, during continuous TCO coating, the workpiece to be coated remains in a good and stable water vapor environment, leading to an excellent performance of the produced TCO-coated workpiece and high production stability.

It should be noted that, when the water vapor partial pressure during the TCO coating process is detected to be greater than 5.0×e⁻³ Pa, the TCO coating process can be stopped immediately, and the ion etching cleaning is then performed on the carrier plate, so as to etch away the residue and the adsorbed moisture on the carrier plate, so that the water vapor pressure is no greater than 5.0×e⁻³ Pa. Alternatively, the TCO coating process continues until completion and the ion etching cleaning is then performed on the carrier plate, so as to etch away the residue and the adsorbed moisture on the carrier plate, so that the water vapor pressure is no greater than 5.0×e⁻³ Pa.

It should be understood that, during continuous TCO coating process, from the beginning to the end of the TCO coating, the water vapor partial pressure is in a dynamic change state with the coating progress. Throughout the coating process, the water vapor partial pressure is continuously detected from the beginning to the end, resulting in a series of the detected values of the water vapor partial pressure, which are also dynamically changing. When the water vapor partial pressure during the TCO coating process is greater than 5.0×e⁻³ Pa, the TCO coating process is stopped and the ion etching cleaning is then performed on the carrier plate, or the TCO coating process continues until completion and the ion etching cleaning is then performed on the carrier plate.

In some embodiments, the water vapor partial pressure can be controlled in a range from 1.0×e⁻³ Pa to 5.0×e⁻³ Pa by adjusting the process conditions of the ion etching cleaning.

In some embodiments, the water vapor partial pressure can be controlled at 2.0×e⁻³ Pa by adjusting the process conditions of the ion etching cleaning.

The process conditions of the ion etching cleaning as described above include the time and/or the pressure of the ion etching cleaning.

Further, the water vapor partial pressure can be controlled in a range from 1.0×e⁻³ Pa to 2.0×e⁻³ Pa by adjusting the time and/or the pressure of the ion etching cleaning.

The water vapor partial pressure refers to a pressure exerted by the water vapor in the air, which can be detected by using methods such as membrane permeation method, fixed point temperature method, or a chemical method. These methods specifically include but are not limited to residual gas analysis (RGA), optical emission (OE) spectroscopy, etc.

In some embodiments, a transparent conductive material used in TCO coating process as described above is at least one selected from the group consisting of a transparent conductive metal, a transparent conductive compound, and a transparent conductive polymer.

Examples of the transparent conductive material include but are not limited to the following:
The transparent conductive material includes the transparent conductive metal, the transparent conductive compound, or the transparent conductive polymer. For example, indium oxide doped with tin, tungsten, titanium, molybdenum, gallium, or hydrogen, and zinc oxide doped with aluminum, gallium, and boron. Non-limiting examples include one or a combination of gold, silver, copper, platinum, In₂O₃, SnO₂, ZnO, TiN, In₂O₃:Sn (ITO), SnO₂:In (IZO), ZnO:Al (AZO), and ZnO:Ga (GZO).

In some embodiments, the workpiece to be coated as described above includes a monocrystalline silicon wafer and an amorphous silicon film loaded on a surface of the monocrystalline silicon wafer.

In some embodiments, the amorphous silicon film includes an intrinsic amorphous silicon film and an n-type doped amorphous silicon film that are stacked in sequence.

In some other embodiments, the amorphous silicon film includes the intrinsic amorphous silicon film and a p-type doped amorphous silicon film that are stacked in sequence.

In a specific example, the workpiece to be coated includes the monocrystalline silicon wafer and a first amorphous silicon film and a second amorphous silicon film that are loaded on both surfaces of the monocrystalline silicon wafer. The first amorphous silicon film includes the intrinsic amorphous silicon film and the n-type doped amorphous silicon film that are stacked in sequence, and the second amorphous silicon film includes the intrinsic amorphous silicon film and the p-type doped amorphous silicon film, so that the TCO-coated workpiece prepared in this manner can be used to prepare the heterojunction solar cell, such as HJT solar cell.

In some embodiments, the monocrystalline silicon wafer is n-type monocrystalline silicon or p-type monocrystalline silicon.

In a specific example, the monocrystalline silicon wafer is n-type monocrystalline silicon.

In some embodiments, the ion etching cleaning is performed at a pressure ranging from 0.3 Pa to 1.3 Pa.

In some embodiments, the ion etching cleaning is performed for 5 min to 15 min.

Furthermore, by adjusting the conditions of the ion etching cleaning, the residual film materials loaded on the carrier plate can be cleaned thoroughly, so that the water vapor partial pressure can be no greater than 5.0×e⁻³ Pa during the coating process.

In some embodiments, an ion source used in the ion etching cleaning is at least one selected from the group consisting of halogen, halogenated compound gas, nitrogen gas, and inert gas.

In some embodiments, the ion source used in the ion etching cleaning includes at least one of halogen and halogenated compound gas, and at least one of nitrogen gas and inert gas.

The halogenated compound gas includes but is not limited to a halogen hydride, and an alkane with 1 to 5 carbon atoms substituted by the halogen.

In some embodiments, the ion source used in the ion etching cleaning is selected from one or a gas combination of Cl₂, HI, HCl, HBr, CH₄, SiCl₄, CCl₄, Ar, He, or N₂.

In some embodiments, the ion source used in the ion etching cleaning includes at least one of Cl₂, HI, HCl, HBr, CH₄, SiCl₄, and CCl₄, and at least one of Ar, He, and N₂.

In some embodiments, the above-described coating process can adopt coating methods and techniques commonly used in the field, including but being not limited to: magnetron sputtering coating technology, thermal evaporation coating technology, plasma reactive deposition technology, dual-target sputtering coating technology, filtered cathodic vacuum arc coating technology, ion-plating technology, or atomic layer deposition coating technology.

In some embodiments, the above-described TCO coating process is performed at a coating pressure of 0.2 Pa to 1.2 Pa, a coating temperature of not higher than 250°C, and an oxygen/argon volume ratio of (0 to 5):100.

When the TCO coating is needed on both sides of the workpiece to be coated, it can be performed successively. The desired thickness of the TCO film can be achieved at one time or by multiple coatings.

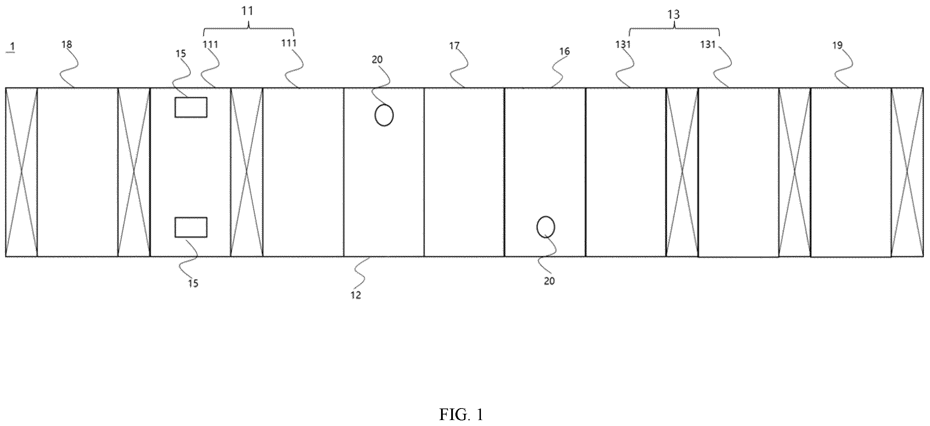

Referring to FIG. 1, an embodiment of the present application provides a TCO coating apparatus for forming a transparent conductive film according to the TCO coating method as described above, including:
a carrier plate 10 (not shown in FIG. 1) configured to load a workpiece to be coated;
a first buffer chamber 11, a first coating chamber 12, and a second buffer chamber 13 that are arranged in sequence, a TCO coating source 20 is provided in the first coating chamber 12 and configured to perform TCO coating process on the workpiece to be coated on the carrier plate 10;
a water vapor partial pressure detecting device 14 (not shown in FIG. 1) configured to detect a water vapor partial pressure in the first coating chamber 12 during the TCO coating process; and
at least one plasma-etching cleaning device 15 provided in at least one of the first buffer chamber 11 and the second buffer chamber 12, and configured to perform ion etching cleaning on the carrier plate 10 to enable the water vapor partial pressure in the first coating chamber 12 to be no greater than 5.0×e⁻³ Pa when the water vapor partial pressure detecting device 14 detects that the water vapor partial pressure is greater than 5.0×e⁻³ Pa, and feeds back to the plasma-etching cleaning device 15.

It should be understood that, the first buffer chamber 11, the first coating chamber 12, and the second buffer chamber 13 are in communication with each other. During operation, the carrier plate 10 loaded with the workpiece to be coated passes through the first buffer chamber 11, then enters the first coating chamber 12 and is subjected to TCO coating process. When the water vapor partial pressure detecting device 14 detects that the maximum water vapor partial pressure in the first coating chamber 12 is greater than 5.0×e⁻³ Pa, the coating process is stopped or continues until completion. The carrier plate enters the second buffer chamber and is subjected to plasma-etching cleaning, or reenters the first buffer chamber 11 again and is subjected to the plasma-etching cleaning, so as to remove the residual film material and the adsorbed moisture on the carrier plate, cutting off the source of water vapor fluctuation from the origin, and ensuring that the water vapor partial pressure in the first coating chamber 12 is no greater than 5.0×e⁻³ Pa.

Specifically, the water vapor partial pressure detecting device 14 (not shown in FIG. 1) is provided in the first coating chamber 12.

Referring still to FIG. 1, the above-described TCO coating apparatus 1 further includes a second coating chamber 16 and an isolation chamber 17. The second coating chamber 16 is provided between the first coating chamber 12 and the second buffer chamber 13. The isolation chamber 17 is provided between the first coating chamber 12 and the second coating chamber 16.

An upper portion of one of the first coating chamber 12 and the second coating chamber 16 is provided with the TCO coating source 12, and a lower portion of the other one of the first coating chamber 12 and the second coating chamber 16 is provided with the TCO coating source 20, such that the TCO coating process is performed on both surfaces of the workpiece to be coated, respectively.

In a specific example, the upper portion of the first coating chamber 12 is provided with the TCO coating source 20 to perform the TCO coating process on the upper surface of the workpiece to be coated; the lower portion of the second coating chamber 16 is provided with the TCO coating source 20 to perform the TCO coating process on the lower surface of the workpiece to be coated.

Furthermore, two water vapor partial pressure detecting devices 14 as described above are provided, and configured to detect partial pressures of the water vapor in the first coating chamber 12 and the second coating chamber 16 during the TCO coating process, respectively.

It should be understood that that one of the two water vapor partial pressure detecting devices is provided in the first coating chamber 14, while the other is provided in the second coating chamber 16.

Referring still to FIG. 1, the plasma-etching cleaning device is provided in at least one of the first buffer chamber 11, the isolation chamber 17, and the second buffer chamber 13, and configured to perform the ion etching cleaning on the carrier plate to enable the water vapor partial pressure in the first coating chamber and the second coating chamber to be no greater than 5.0×e⁻³ Pa when the water vapor partial pressure detected by the water vapor partial pressure monitoring device is greater than 5.0×e⁻³ Pa.

It should be noted that when both the first coating chamber 12 and the second coating chamber 16 are provided, as long as the water vapor partial pressure in one of the coating chambers is greater than 5.0×e⁻³ Pa, the ion etching cleaning is performed on the carrier plate 10.

In some embodiments, two plasma-etching cleaning devices 15 are provided, one plasma-etching cleaning device 15 is located at the upper portion of any one of the first buffer chamber 11, the isolation chamber 17, and the second buffer chamber 13, and another plasma-etching cleaning device 15 is located at the lower portion of any one of the first buffer chamber 11, the isolation chamber 17, and the second buffer chamber 13, such that the ion etching cleaning is performed on upper and lower surfaces of the carrier plate.

It should be understood that, two plasma-etching cleaning devices 15 can simultaneously be located in any one of the first buffer chamber 11, the isolation chamber 17, and the second buffer chamber 13, and can be respectively positioned at the upper and lower portions of the chamber. Alternatively, the two plasma-etching cleaning devices 15 can be located in any two of the first buffer chamber 11, the isolation chamber 17, and the second buffer chamber 13.

In some embodiments, two plasma-etching cleaning devices 15 can be simultaneously located in the first buffer chamber 11, and are positioned at the upper and lower portions of the first buffer chamber 11, respectively.

Furthermore, the first buffer chamber 11 has a plurality of first buffer sub-chambers 111 adjacent to and in communication with each other. Referring still to FIG. 1, the first buffer chamber 11 has two adjacent first buffer sub-chambers 111 in communication with each other.

In some embodiments, two plasma-etching cleaning devices 15 can be simultaneously located in one of the first buffer sub-chambers 111, and are positioned at the upper and lower portions thereof, respectively. In some other embodiments, one plasma-etching cleaning device 15 is positioned at the upper portion of one first buffer sub-chamber 111, while another plasma-etching cleaning device 15 is positioned at the lower portion of another first buffer sub-chamber 111.

Similarly, in some embodiments, two plasma-etching cleaning devices 15 can be simultaneously located in the second buffer chamber 13, and are positioned at the upper and lower portions of the second buffer chamber 13, respectively.

Furthermore, the second buffer chamber 13 also has a plurality of second buffer sub-chambers 131 adjacent to and in communication with each other. Referring still to FIG. 1, the second buffer chamber 13 has two adjacent second buffer sub-chambers 131 in communication with each other.

In some embodiments, two plasma-etching cleaning devices 15 can be simultaneously located in one of the second buffer sub-chambers 131, and are positioned at the upper and lower portions of the second buffer sub-chambers 131, respectively. In some other embodiments, one plasma-etching cleaning device 15 is positioned at the upper portion of one second buffer sub-chamber 131, while another plasma-etching cleaning device 15 is positioned at the lower portion of another second buffer sub-chamber 131.

In some embodiments, the TCO coating apparatus further includes a feed chamber 18 and a discharge chamber 19, the feed chamber is provided upstream of the first buffer chamber 11 for feeding, and the discharge chamber 19 is provided downstream of the second buffer chamber 13 for discharging.

It should be noted that, the "upstream" and "downstream" are relative positions distinguished based on the feed direction of the workpiece to be coated in the TCO coating device. The end adjacent to the feed is the upstream, while the end adjacent to the discharge is the downstream. For example, in the first buffer chamber 11, the end adjacent to the inlet for the workpiece to be coated is the upstream, while in the second buffer chamber 13, the end adjacent to the outlet is the downstream.

The workpiece to be coated and the carrier plate 10 enter from the feed chamber 17, and are discharged from the discharge chamber 19 after the TCO coating is completed.

It should be understood that, the various adjacent chambers in the above TCO coating apparatus 1 are in communication with each other.

In some embodiments, the plasma-etching cleaning device is selected from the group consisting of an electron cyclotron reactor, an inductive coupler, a capacitive coupler, a dual plasma source reactor, and a magnetic enhanced reaction ion etching reactor or a combination thereof. The water vapor partial pressure detecting device is selected from the group consisting of a residual gas analyzer, a spectrum analyzer, or a combination thereof. Specifically, the above-described coating apparatus 1 for the silicon wafer also includes a vacuum pump device, a heating device, a transporting device, a cold trap device and the like. The vacuum pump device is configured to create vacuum conditions in the coating chamber 111 during the coating process. The transporting device and the cold trap device are respectively configured to heat and cool the coating chamber during the coating process, thus controlling the temperature in the coating chamber 111. The transporting device is configured to control the movement of the carrier plate within each chamber of the coating apparatus 1 during continuous production.

An embodiment of the present application provides a method for preparing a solar cell, including steps S20 to S30:
S20, a monocrystalline silicon wafer is subjected to surface texturing and chemical cleaning process to obtain a textured monocrystalline silicon wafer.

The monocrystalline silicon wafer is subjected to the surface texturing to form a pyramidal concave-convex structure with improved light absorption, and then subjected to the chemical cleaning to form a clean surface. The monocrystalline silicon wafer can be n-type monocrystalline silicon wafer or p-type monocrystalline silicon wafer.

S30, an amorphous silicon film is formed on a surface of the textured monocrystalline silicon wafer, then a transparent conductive film is formed, and finally an electrode is prepared to obtain a solar cell.

The step of forming the transparent conductive film is performed according to the TCO coating method as described above or using the TCO coating apparatus as described above.

The above TCO coating method and TCO coating apparatus can cut off the source of water vapor fluctuation from the origin, ensuring that the workpiece to be coated are always in a good and stable water vapor environment during the continuous TCO coating process for solar cell preparation, improving the contact performance of the amorphous silicon/TCO and the photoelectronic performance of the TCO film, and enhancing production stability.

In some embodiments, the step of forming the amorphous silicon film as described above includes the following steps:
The intrinsic amorphous silicon films are formed on the upper and lower surfaces of a textured n-type monocrystalline silicon wafer, respectively, and then the p-type doped amorphous silicon film and the n-type doped amorphous silicon film are formed on the upper and lower surfaces respectively. Further, the transparent conductive films are formed on the upper and lower surfaces, and finally the electrodes are prepared, obtaining the solar cell, specifically an HJT heterojunction cell.

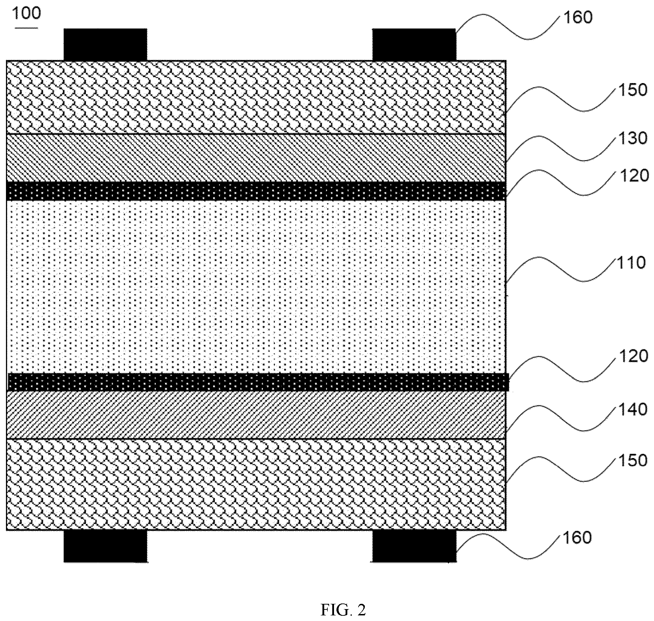

Referring to FIG. 2, which is a schematic structural view of an HJT heterojunction cell 100 according to an embodiment of the present application. Specifically, the HJT heterojunction cell 100 is prepared as follows: A n-type crystalline silicon wafer 110 after texturing and cleaning is placed into a device for depositing amorphous silicon films to deposit intrinsic amorphous silicon films 120 on the upper and lower surfaces of the silicon wafer, where the thickness of the intrinsic amorphous silicon film is in a range from 4nm to 9nm. Then, p-type doped amorphous silicon film 130 and n-type doped amorphous silicon film 140 are deposited on the upper and lower surfaces, respectively, where the thickness of the doped amorphous silicon film is in a range from 5 nm to 20 nm. Then, transparent conductive films 150 with a thickness ranging from 50 nm to 90 nm are deposited on the upper and lower surfaces, respectively. Metal electrodes 160 are then deposited on the upper and lower surfaces of the transparent conductive film 150.

In some embodiments, the steps of preparing the electrodes include the following:
A silver paste is screen printed on the surfaces of the transparent conductive film, and then sintered at 170 °C to 200 °C to form the metal electrodes 160.

It should be noted that, the above-described preparation method of the solar cell is not limited to preparing the HJT heterojunction solar cell, but can also be used for preparing the HBC cell (referred to as an interdigital back-contact heterojunction solar cell), or the stacked solar cell. For example, when preparing the HBC cells, step S30 is as follow: an intrinsic amorphous silicon passivation layer, n-type amorphous silicon layer and an antireflection layer are formed sequentially on the front surface of a textured monocrystalline silicon wafer, and an intrinsic amorphous silicon passivation layer, a p-type amorphous silicon layer and an n-type amorphous silicon layer are formed sequentially on the back surface of the textured monocrystalline silicon wafer. The TCO conductive films then are formed, and finally electrodes are formed to obtain the HBC cell. An embodiment of the present application provides a solar cell, which is prepared by the solar cell preparation method as described above.

In the solar cell prepared by the solar cell preparation method as described above, the amorphous silicon film has good contact performance with the TCO film, and the efficiency of the solar cell is high.

The present application will be described below in conjunction with specific examples, but the present application is not limited to the following examples. It should be understood that the appended claims summarize the scope of the present application, and under the concept of the present application, those skilled in the art should be aware that certain modifications to the various embodiments of the present application, should be covered by the scope of the claims of the present application.

Specific examples are as follows.

### Example 1

Experiment 1: Verifying the effect of the water vapor partial pressure on cell performance during TCO coating.
(1) A n-type crystalline silicon wafer after texturing and cleaning is placed into a TCO coating chamber for depositing the amorphous silicon film to deposit intrinsic amorphous silicon films on the upper and lower surfaces of the silicon wafer, where the thickness of the intrinsic amorphous silicon film is 9nm. Then, p-type doped amorphous silicon film and n-type doped amorphous silicon film are deposited on the upper and lower surfaces, respectively, where the thickness of the doped amorphous silicon film is 20 nm, obtaining a silicon wafer to be coated.
(2) The silicon wafer to be coated is loaded onto the carrier plate and introduced into the TCO coating chamber for TCO coating process. Transparent conductive films with a thickness of 50 nm are deposited on the upper and lower surfaces by a coating target, respectively, to obtain a TCO coated workpiece.

In each coating process, the process control parameters are consistent. Specifically: the TCO film is deposited on the front surface by using 973 target, with a sputtering power density of 4 kW/m, in an Ar/O₂ ratio of 2%, and at a coating pressure of 0.35 Pa and a coating temperature of 180 °C. The TCO film is deposited on the back surface by using 9010 target, with a sputtering power density of 5 kW/m, in an Ar/O₂ ratio of 3.5%, and at a coating pressure of 0.45 Pa and a coating temperature of 180 °C.

The deposition on the front surface and the deposition on the back surface are performed in two separate coating chambers, where each coating chambers is equipped with the water vapor detecting device to detect the water vapor partial pressure in the coating chambers. After coating, the TCO film coated silicon wafer is unloaded, and the carrier plate is cycled back into the coating operation described in step (2). The maximum value of the water vapor partial pressure in the coating chamber (i.e., the higher value of the water vapor partial pressure in the two coating cavities) and the thickness of the deposited film layer on the carrier plate is recorded after different cycles (RUN). Please refer to Table 1 for details.

(3) A silver paste is screen printed on the above TCO coated workpiece, and then sintered at 170 °C to 200 °C to form metal electrodes, obtaining an HJT heterojunction cell. The performance of the HJT heterojunction cell is then tested according to the standard GB/T6495.1-1996.

Voc represents an open-circuit voltage (mV), Isc represents a short-circuit current (A), FF represents a fill factor, EFF represents conversion efficiency (%).

The specific results are shown in Table 1.

**Table 1**

| | Eff(%) | Voc(mV) | Isc(A) | FF(%) | Thickness of the residual film on the carrier plate (µm) | Water vapor partial pressure (Pa) |
|---|---|---|---|---|---|---|
| 10RUN | 24.01 | 0.7403 | 9.421 | 84.09 | 1 | 1.0×10⁻³ |
| 100RUN | 24.13 | 0.7409 | 9.410 | 84.55 | 10 | 2.0×10⁻³ |
| 500RUN | 24.17 | 0.7412 | 9.412 | 84.63 | 50 | 5.0×10⁻³ |
| 600RUN | 23.79 | 0.7394 | 9.405 | 83.59 | 60 | 1.0×10⁻² |
| 1000RUN | 23.72 | 0.7394 | 9.401 | 83.34 | 100 | 5.0×10⁻² |

From the data in Table 1, it can be seen that in continuous production, the water vapor partial pressure (Pa) in the coating chamber can gradually increase, and the efficiency of the cell can increase firstly and then rapidly decrease with the increase of times that the carrier plate is used. At 500 RUN, the conversion efficiency (EFF) of the cell is the highest, reaching 24.18%, and then sharply decreases. At 1000 RUN, the conversion efficiency of the cell decreases to 23.72%.

Experiment 2: Verifying the effect of residual water vapor on the carrier plate on the cell
The above experiment 1 is repeated, when the thickness of the residual film on the carrier plate is 60 µm, after the TCO coating is completed, the carrier plate is taken out and introduced into the buffer chamber. The upper and lower portions of the buffer chamber are respectively provided with plasma-etching cleaning devices, and the upper and lower surfaces of the carrier plate are subjected to plasma-etching cleaning, with etching gases of SiCl₄ and Ar, at an etching pressure of 0.5 Pa and an etching power density of 1 w/cm² for a cleaning time of 5 minutes. Then, the above steps (2) to (3) are repeated using the cleaned carrier plate. The water vapor partial pressure in the coating chamber and the performance of the prepared cell are shown in Table 2.

Experiment 3: Experiment 3 is basically the same as Experiment 2, except that the cleaning time in Experiment 3 lasts 10 minutes. The water vapor partial pressure in the coating chamber and the performance of the prepared cell are shown in Table 2.

**Table 2**

| | Eff(%) | Voc(mV) | Isc(A) | FF(%) | Partial pressure of residual water vapor (Pa) |
|---|---|---|---|---|---|
| Cleaning for 5min | 24.06 | 0.7405 | 9.410 | 84.35 | 4.5E⁻³ |
| Cleaning for 10min | 24.18 | 0.7415 | 9.412 | 84.65 | 1.5E⁻³ |

From the data in Table 2, it can be seen that when the carrier plate is subjected to the plasma-etching cleaning for 5 minutes, the corresponding residual water vapor amount in the coating chamber decreases from 1.0 E⁻² to 4.5 E⁻³, and the efficiency of the cell recovers to 24.06%, which is significantly improved and reaches a good level. Further, when the carrier plate is subjected to the plasma-etching cleaning for 10 minutes, the corresponding residual water vapor amount decreases from 1.0 E⁻² to 1.5 E⁻³, and the efficiency of the cell recovers to 24.18%, which is significantly improved and reaches an excellent level. It can be seen that during continuous TCO coating, the residue on the carrier plate has an important impact on the water vapor partial pressure. Through ion etching cleaning for the carrier plate, the source of the water vapor fluctuation of the heterojunction cell can be cut off from the origin during TCO coating, so that the TCO coating can be performed under stable and suitable water vapor conditions, and the heterojunction cell obtained has stable performance and high efficiency.

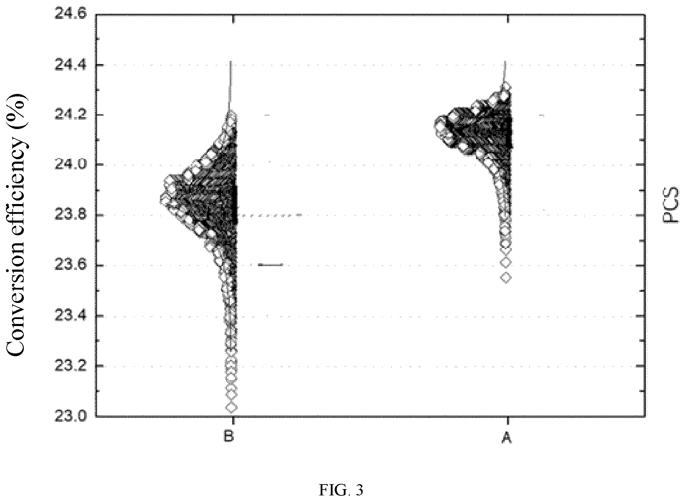

Experiment 4: Experiment 4 is basically the same as Experiment 3, except that by adjusting the time of ion etching cleaning, the water vapor partial pressure in the coating chamber is maintained at 2E⁻³ Pa or less. 10,000 pieces (pcs) of heterojunction cells are continuously prepared, and the conversion efficiency distribution diagram is shown in A of FIG. 3.

Experiment 5: Experiment 5 is basically the same as Experiment 4, except that the water vapor partial pressure in the coating chamber is maintained at 6E⁻³ Pa or above. 10,000 pieces (pcs) of heterojunction cells were continuously prepared, and the conversion efficiency distribution diagram is shown in B of FIG. 3.

From the distribution trend of the conversion efficiency of the heterojunction cells in A and B of FIG. 3, it can be seen that when continuous production is carried out by using the TCO coating method for the HJT heterojunction cell of the present application, the water vapor residual amount is detected and the carrier plate with the water vapor residual amount exceeding the standard is subjected to the plasma-etching cleaning to cut off the source of the water vapor fluctuation from the origin, so that the negative impact of unstable water vapor fluctuation on the conversion efficiency of the prepared HJT heterojunction cell is addressed, thereby effectively improving the yield and efficiency of the product during large-scale production of the HJT heterojunction cells, and the dispersion rate is small, and the stability during large-scale production is high.

## Claims

1. A TCO coating method, comprising the following steps of:
loading a workpiece to be coated onto a carrier plate (10), and performing TCO coating process on the workpiece to be coated;
detecting a water vapor partial pressure during the TCO coating process; and
**characterised in that** the method further comprises stopping the TCO coating process or continuing to complete the TCO coating process when the water vapor partial pressure during the TCO coating process is detected to be greater than 5.0×e⁻³ Pa, and then performing ion etching cleaning on the carrier plate (10) to enable the water vapor partial pressure to be no greater than 5.0×e⁻³ P^{a}.

2. The TCO coating method according to claim 1, wherein the ion etching cleaning is performed for 5 min to 15 min.

3. The TCO coating method according to any one of claims 1 to 2, wherein the ion etching cleaning is performed at a pressure ranging from 0.3 Pa to 1.3 Pa.

4. The TCO coating method according to any one of claims 1 to 3, wherein an ion source used in the ion etching cleaning is at least one selected from the group consisting of halogen, halogenated compound gas, nitrogen gas, and inert gas;
preferably, an ion source used in the ion etching cleaning comprises at least one of halogen and halogenated compound gas, and at least one of nitrogen gas and inert gas.

5. The TCO coating method according to any one of claims 1 to 4, wherein a transparent conductive material used during the TCO coating process is at least one selected from the group consisting of a transparent conductive metal, a transparent conductive compound, and a transparent conductive polymer.

6. The TCO coating method according to any one of claims 1 to 5, wherein the workpiece to be coated comprises a monocrystalline silicon wafer and an amorphous silicon film loaded on a surface of the monocrystalline silicon wafer.

7. The TCO coating method according to claim 6, wherein the amorphous silicon film comprises an intrinsic amorphous silicon film and a p-type doped amorphous silicon film that are stacked in sequence; or
the amorphous silicon film comprises an intrinsic amorphous silicon film and an n-type doped amorphous silicon film that are stacked in sequence.

8. A TCO coating apparatus (1), comprising:
a carrier plate (10) configured to load a workpiece to be coated;
a first buffer chamber (11), a first coating chamber (12), and a second buffer chamber (13) that are arranged in sequence, wherein a TCO coating source (20) is provided in the first coating chamber (12) and configured to perform TCO coating process on the workpiece to be coated on the carrier plate (10);
a water vapor partial pressure detecting device (14) configured to detect a water vapor partial pressure in the first coating chamber (12) during the TCO coating process;
**characterised in that** the TCO coating apparatus further comprises at least one plasma-etching cleaning device (15) provided in at least one of the first buffer chamber (11) and the second buffer chamber (13), when the water vapor partial pressure detected by the water vapor partial pressure detecting device (14) is greater than 5.0×e⁻³ Pa, wherein at least one plasma-etching cleaning device (15) is configured to perform ion etching cleaning on the carrier plate (10) to enable the water vapor partial pressure in the first coating chamber (12) to be no greater than 5.0×e⁻³ Pa; and
wherein the TCO coating apparatus is for forming a transparent conductive film according to the TCO coating method of any one of claims 1 to 7.

9. The TCO coating apparatus (1) according to claim 8, wherein the TCO coating apparatus (1) further comprises a second coating chamber (16) and an isolation chamber (17), the second coating chamber (16) is provided between the first coating chamber (12) and the second buffer chamber (13), and the isolation chamber (17) is provided between the first coating chamber (12) and the second coating chamber (16);
wherein an upper portion of one of the first coating chamber (12) and the second coating chamber (16) is provided with the TCO coating source (20), and a lower portion of another one of the first coating chamber (12) and the second coating chamber (16) is provided with the TCO coating source (20), such that the TCO coating process is performed on both surfaces of the workpiece to be coated, respectively;
wherein two water vapor partial pressure detecting devices (14) are provided, and the two water vapor partial pressure detecting devices (14) are configured to detect the water vapor partial pressure in the first coating chamber (12) and the second coating chamber (16) during the TCO coating process, respectively;
wherein the plasma-etching cleaning device (15) is provided in at least one of the first buffer chamber (11), the isolation chamber (17), and the second buffer chamber (13), and the plasma-etching cleaning device (15) is configured to perform the ion etching cleaning on the carrier plate (10) to enable the water vapor partial pressure in the first coating chamber (12) and the second coating chamber (16) to be no greater than 5.0×e⁻³ Pa when the water vapor partial pressure detected by the water vapor partial pressure detecting device (14) is greater than 5.0×e⁻³ Pa.

10. The TCO coating apparatus (1) according to claim 9, wherein two plasma-etching cleaning devices (15) are provided, one plasma-etching cleaning device (15) is located at the upper portion of any one of the first buffer chamber (11), the isolation chamber (17), and the second buffer chamber (13), and another plasma-etching cleaning device (15) is located at the lower portion of any one of the first buffer chamber (11), the isolation chamber (17), and the second buffer chamber (13), such that the ion etching cleaning is performed on upper and lower surfaces of the carrier plate (10).

11. The TCO coating apparatus (1) according to any one of claims 8 to 10, wherein the TCO coating apparatus (1) further comprises a feed chamber (18) and a discharge chamber (19), the feed chamber (18) is provided upstream of the first buffer chamber (11) for feeding, and the discharge chamber (19) is provided downstream of the second buffer chamber (13) for discharging.

12. The TCO coating apparatus (1) according to any one of claims 8 to 11, wherein the plasma-etching cleaning device (15) is selected from the group consisting of an electron cyclotron reactor, an inductive coupler, a capacitive coupler, a dual plasma source reactor, a magnetic enhanced reaction ion etching reactor, or a combination thereof; or
the water vapor partial pressure detecting device (14) is selected from the group consisting of a residual gas analyzer, a spectrum analyzer, or a combination thereof.

13. A method for preparing a solar cell, comprising the following steps of:
subjecting a monocrystalline silicon wafer to surface texturing and chemical cleaning process to obtain a textured monocrystalline silicon wafer; and
forming an amorphous silicon film on a surface of the textured monocrystalline silicon wafer, then forming a transparent conductive film, and finally preparing an electrode to obtain a solar cell;
**characterised in that** the step of forming the transparent conductive film is performed according to the TCO coating method according to any one of claims 1 to 7 or using the TCO coating apparatus (1) according to any one of claims 8 to 12.

14. The method for preparing the solar cell according to claim 13, wherein the step of forming the amorphous silicon film comprises a following step of:
forming intrinsic amorphous silicon films on upper and lower surfaces of the textured monocrystalline silicon wafer respectively, and then forming a p-type doped amorphous silicon film and a n-type doped amorphous silicon film on the upper and lower surfaces respectively; or
the step of preparing the electrode comprises a following step of:
screen printing a silver paste on surfaces of the transparent conductive film, and then sintering at 170 °C to 200 °C.

## Patentansprüche

1. TCO-Beschichtungsverfahren, umfassend die folgenden Schritte:
Aufbringen eines zu beschichtenden Werkstücks auf eine Trägerplatte (10) und Durchführen eines TCO-Beschichtungsprozesses an dem zu beschichtenden Werkstück;
Detektieren des Wasserdampfpartialdrucks während des TCO-Beschichtungsprozesses; und
**dadurch gekennzeichnet, dass** das Verfahren weiter Stoppen des TCO-Beschichtungsprozesses oder Fortsetzen zum Abschließen des TCO-Beschichtungsprozesses umfasst, wenn detektiert wird, dass der Wasserdampfpartialdruck während des TCO-Beschichtungsprozesses größer als 5,0 × e⁻³ Pa ist, und dann Durchführen einer Ionenätzreinigung an der Trägerplatte (10), um zu ermöglichen, dass der Wasserdampfpartialdruck nicht größer als 5,0 × e⁻³ Pa ist.

2. TCO-Beschichtungsverfahren nach Anspruch 1, wobei die Ionenätzreinigung 5 min bis 15 min lang durchgeführt wird.

3. TCO-Beschichtungsverfahren nach einem der Ansprüche 1 bis 2, wobei die Ionenätzreinigung bei einem Druck im Bereich von 0,3 Pa bis 1,3 Pa durchgeführt wird.

4. TCO-Beschichtungsverfahren nach einem der Ansprüche 1 bis 3, wobei eine bei der Ionenätzreinigung verwendete Ionenquelle mindestens eine ist, die aus der Gruppe ausgewählt ist, bestehend aus Halogen, halogeniertem Gasgemisch, Stickstoffgas und Inertgas;
vorzugsweise umfasst eine bei der Ionenätzreinigung verwendete Ionenquelle mindestens eines aus Halogen und halogeniertem Gasgemisch und mindestens eines aus Stickstoffgas und Inertgas.

5. TCO-Beschichtungsverfahren nach einem der Ansprüche 1 bis 4, wobei ein während des TCO-Beschichtungsprozesses verwendetes transparent leitfähiges Material mindestens eines ist, das aus der Gruppe ausgewählt ist, bestehend aus einem transparenten, leitfähigen Metall, einer transparenten, leitfähigen Verbindung und einem transparenten, leitfähigen Polymer.

6. TCO-Beschichtungsverfahren nach einem der Ansprüche 1 bis 5, wobei das zu beschichtende Werkstück einen monokristallinen Siliziumwafer und einen auf einer Oberfläche des monokristallinen Siliziumwafers aufgebrachten amorphen Siliziumfilm umfasst.

7. TCO-Beschichtungsverfahren nach Anspruch 6, wobei der amorphe Siliziumfilm einen intrinsischen amorphen Siliziumfilm und einen p-dotierten amorphen Siliziumfilm umfasst, die nacheinander gestapelt sind; oder
der amorphe Siliziumfilm einen intrinsischen amorphen Siliziumfilm und einen n-dotierten amorphen Siliziumfilm umfasst, die nacheinander gestapelt sind.

8. TCO-Beschichtungseinrichtung (1), umfassend:
eine Trägerplatte (10), die zum Auflegen eines zu beschichtenden Werkstücks ausgebildet ist;
eine erste Pufferkammer (11), eine erste Beschichtungskammer (12) und eine zweite Pufferkammer (13), die nacheinander angeordnet sind, wobei in der ersten Beschichtungskammer (12) eine TCO-Beschichtungsquelle (20) bereitgestellt und ausgebildet ist, um einen TCO-Beschichtungsprozess an dem zu beschichtenden Werkstück auf der Trägerplatte (10) durchzuführen;
eine Wasserdampfpartialdruckdetektionsvorrichtung (14), die ausgebildet ist, um während des TCO-Beschichtungsprozesses einen Wasserdampfpartialdruck in der ersten Beschichtungskammer (12) zu detektieren;
**dadurch gekennzeichnet, dass** die TCO-Beschichtungseinrichtung weiter mindestens eine Plasmaätzreinigungsvorrichtung (15) umfasst, die in mindestens einer der ersten Pufferkammer (11) und der zweiten Pufferkammer (13) bereitgestellt ist, wenn der von der Wasserdampfpartialdruckdetektionsvorrichtung (14) detektierte Wasserdampfpartialdruck größer als 5,0×e⁻³ Pa ist, wobei mindestens eine Plasmaätzreinigungsvorrichtung (15) ausgebildet ist, um eine Ionenätzreinigung an der Trägerplatte (10) durchzuführen, um zu ermöglichen, dass der Wasserdampfpartialdruck in der ersten Beschichtungskammer (12) nicht größer als 5,0 × e⁻³ Pa ist; und
wobei die TCO-Beschichtungseinrichtung dazu dient, einen transparenten leitfähigen Film nach dem TCO-Beschichtungsverfahren nach einem der Ansprüche 1 bis 7 zu bilden.

9. TCO-Beschichtungseinrichtung (1) nach Anspruch 8, wobei die TCO-Beschichtungseinrichtung (1) weiter eine zweite Beschichtungskammer (16) und eine Isolationskammer (17) umfasst, wobei die zweite Beschichtungskammer (16) zwischen der ersten Beschichtungskammer (12) und der zweiten Pufferkammer (13) bereitgestellt ist und die Isolationskammer (17) zwischen der ersten Beschichtungskammer (12) und der zweiten Beschichtungskammer (16) bereitgestellt ist;
wobei ein oberer Abschnitt von einem aus der ersten Beschichtungskammer (12) und der zweiten Beschichtungskammer (16) mit der TCO-Beschichtungsquelle (20) bereitgestellt ist, und ein unterer Abschnitt eines anderen aus der ersten Beschichtungskammer (12) und der zweiten Beschichtungskammer (16) mit der TCO-Beschichtungsquelle (20) bereitgestellt ist, so dass der TCO-Beschichtungsprozess jeweils an beiden Oberflächen des zu beschichtenden Werkstücks durchgeführt wird;
wobei zwei Wasserdampfpartialdruckdetektionsvorrichtungen (14) bereitgestellt sind und die zwei Wasserdampfpartialdruckdetektionsvorrichtungen (14) ausgebildet sind, um den Wasserdampfpartialdruck während des TCO-Beschichtungsprozesses jeweils in der ersten Beschichtungskammer (12) und der zweiten Beschichtungskammer (16) zu detektieren;
wobei die Plasmaätzreinigungsvorrichtung (15) in mindestens einem aus der ersten Pufferkammer (11), der Isolationskammer (17) und der zweiten Pufferkammer (13) bereitgestellt ist und die Plasmaätzreinigungsvorrichtung (15) ausgebildet ist, um die Ionenätzreinigung an der Trägerplatte (10) durchzuführen, um zu ermöglichen, dass der Wasserdampfpartialdruck in der ersten Beschichtungskammer (12) und der zweiten Beschichtungskammer (16) nicht größer als 5,0×e⁻³ Pa ist, wenn der von der Wasserdampfpartialdruckdetektionsvorrichtung (14) detektierte Wasserdampfpartialdruck größer als 5,0 × e⁻³ Pa ist.

10. TCO-Beschichtungseinrichtung (1) nach Anspruch 9, wobei zwei Plasmaätzreinigungsvorrichtungen (15) bereitgestellt sind, wobei eine Plasmaätzreinigungsvorrichtung (15) im oberen Abschnitt von einem aus der ersten Pufferkammer (11), der Isolationskammer (17) oder der zweiten Pufferkammer (13) lokalisiert ist, und eine weitere Plasmaätzreinigungsvorrichtung (15) im unteren Abschnitt von einem aus der ersten Pufferkammer (11), der Isolationskammer (17) oder der zweiten Pufferkammer (13) lokalisiert ist, sodass die Ionenätzreinigung an den oberen und unteren Oberflächen der Trägerplatte (10) durchgeführt wird.

11. TCO-Beschichtungseinrichtung (1) nach einem der Ansprüche 8 bis 10, wobei die TCO-Beschichtungseinrichtung (1) weiter eine Zuführkammer (18) und eine Entladekammer (19) umfasst, wobei die Zuführkammer (18) stromaufwärts der ersten Pufferkammer (11) zum Zuführen bereitgestellt ist, und die Entladekammer (19) stromabwärts der zweiten Pufferkammer (13) zum Entladen bereitgestellt ist.

12. TCO-Beschichtungseinrichtung (1) nach einem der Ansprüche 8 bis 11, wobei die Plasmaätzreinigungsvorrichtung (15) aus der Gruppe ausgewählt ist, die aus einem Elektronenzyklotronreaktor, einem induktiven Koppler, einem kapazitiven Koppler, einem Reaktor mit doppelter Plasmaquelle, einem Reaktor für magnetisch verstärktes Reaktionsionenätzen oder einer Kombination davon besteht; oder
die Wasserdampfpartialdruckdetektionsvorrichtung (14) aus der Gruppe ausgewählt ist, die aus einem Restgasanalysator, einem Spektrumanalysator oder einer Kombination davon besteht.

13. Verfahren zum Präparieren einer Solarzelle, umfassend die folgenden Schritte:
Unterwerfen eines monokristallinen Siliziumwafers unter einem Oberflächentexturierungs- und chemischen Reinigungsprozess, um einen texturierten monokristallinen Siliziumwafer zu erhalten; und
Bilden eines amorphen Siliziumfilms auf einer Oberfläche des texturierten monokristallinen Siliziumwafers, dann Bilden eines transparenten leitfähigen Films und schließlich Präparieren einer Elektrode, um eine Solarzelle zu erhalten;
**dadurch gekennzeichnet, dass** der Schritt des Bildens des transparenten leitfähigen Films nach dem TCO-Beschichtungsverfahren nach einem der Ansprüche 1 bis 7 oder unter Verwendung der TCO-Beschichtungseinrichtung (1) nach einem der Ansprüche 8 bis 12 durchgeführt wird.

14. Verfahren zum Präparieren der Solarzelle nach Anspruch 13, wobei der Schritt des Bildens des amorphen Siliziumfilms einen folgenden Schritt umfasst:
Bilden von intrinsischen amorphen Siliziumfilmen auf der oberen und unteren Oberfläche des texturierten monokristallinen Siliziumwafers und dann Bilden eines p-dotierten amorphen Siliziumfilms und eines n-dotierten amorphen Siliziumfilms entsprechend auf der oberen und unteren Oberfläche; oder
der Schritt des Präparierens der Elektrode einen folgenden Schritt umfasst:
Siebdrucken einer Silberpaste auf Oberflächen des transparenten leitfähigen Films und dann Sintern bei 170 °C bis 200 °C.

## Revendications

1. Procédé de revêtement de TCO, comprenant les étapes de :
chargement d'une pièce devant être revêtue sur une plaque de support (10), et réalisation d'un traitement de revêtement de TCO sur la pièce devant être revêtue ;
détection d'une pression partielle de vapeur d'eau pendant le traitement de revêtement de TCO ; et
**caractérisé en ce que** le procédé comprend en outre l'arrêt du traitement de revêtement de TCO ou sa poursuite pour achever le traitement de revêtement de TCO lorsque la pression partielle de vapeur d'eau pendant le traitement de revêtement de TCO est détectée comme étant supérieure à 5,0×e⁻³ Pa, puis la réalisation d'un nettoyage par gravure ionique sur la plaque de support (10) afin de permettre à la pression partielle de vapeur d'eau de ne pas être supérieure à 5,0×e⁻³ Pa.

2. Procédé de revêtement de TCO selon la revendication 1, dans lequel le nettoyage par gravure ionique est réalisé pendant 5 min à 15 min.

3. Procédé de revêtement de TCO selon l'une quelconque des revendications 1 à 2, dans lequel le nettoyage par gravure ionique est réalisé à une pression allant de 0,3 Pa à 1,3 Pa.

4. Procédé de revêtement de TCO selon l'une quelconque des revendications 1 à 3, dans lequel une source d'ions utilisée dans le nettoyage par gravure ionique est au moins un élément sélectionné dans le groupe consistant en halogène, gaz composé halogéné, azote gazeux, et gaz inerte ;
de préférence, une source d'ions utilisée dans le nettoyage par gravure ionique comprend au moins un halogène et/ou un gaz composé halogéné, et au moins un azote gazeux et un gaz inerte.

5. Procédé de revêtement de TCO selon l'une quelconque des revendications 1 à 4, dans lequel un matériau conducteur transparent utilisé lors du traitement de revêtement de TCO est au moins un élément sélectionné dans le groupe consistant en un métal conducteur transparent, un composé conducteur transparent, et un polymère conducteur transparent.

6. Procédé de revêtement de TCO selon l'une quelconque des revendications 1 à 5, dans lequel la pièce devant être revêtue comprend une tranche de silicium monocristallin et un film de silicium amorphe chargé sur une surface de la tranche de silicium monocristallin.

7. Procédé de revêtement de TCO selon la revendication 6, dans lequel le film de silicium amorphe comprend un film de silicium amorphe intrinsèque et un film de silicium amorphe dopé de type p qui sont empilés en séquence ; ou
le film de silicium amorphe comprend un film de silicium amorphe intrinsèque et un film de silicium amorphe dopé de type n qui sont empilés en séquence.

8. Appareil de revêtement de TCO (1), comprenant :
une plaque de support (10) configurée pour charger une pièce devant être revêtue ;
une première chambre tampon (11), une première chambre de revêtement (12) et une deuxième chambre tampon (13) qui sont agencées en séquence, dans lequel une source de revêtement de TCO (20) est disposée dans la première chambre de revêtement (12) et configurée pour réaliser un procédé de revêtement de TCO sur la pièce devant être revêtue sur la plaque de support (10) ;
un dispositif de détection de pression partielle de vapeur d'eau (14) configuré pour détecter une pression partielle de vapeur d'eau dans la première chambre de revêtement (12) pendant le processus de revêtement de TCO ;
**caractérisé en ce que** l'appareil de revêtement de TCO comprend en outre au moins un dispositif de nettoyage par gravure au plasma (15) disposé dans au moins l'une de la première chambre tampon (11) et de la deuxième chambre tampon (13), lorsque la pression partielle de vapeur d'eau détectée par le dispositif de détection de pression partielle de vapeur d'eau (14) est supérieure à 5,0×e⁻³ Pa, dans lequel au moins un dispositif de nettoyage par gravure au plasma (15) est configuré pour réaliser un nettoyage par gravure ionique sur la plaque de support (10) afin que la pression partielle de vapeur d'eau dans la première chambre de revêtement (12) ne soit pas supérieure à 5,0×e⁻³ Pa ; et
dans lequel l'appareil de revêtement de TCO est destiné à la formation d'un film conducteur transparent selon le procédé de revêtement de TCO selon l'une quelconque des revendications 1 à 7.

9. Appareil de revêtement de TCO (1) selon la revendication 8, dans lequel l'appareil de revêtement de TCO (1) comprend en outre une deuxième chambre de revêtement (16) et une chambre d'isolation (17), la deuxième chambre de revêtement (16) est disposée entre la première chambre de revêtement (12) et la deuxième chambre tampon (13), et la chambre d'isolation (17) est disposée entre la première chambre de revêtement (12) et la deuxième chambre de revêtement (16) ;
dans lequel une partie supérieure de l'une de la première chambre de revêtement (12) et de la deuxième chambre de revêtement (16) est dotée de la source de revêtement de TCO (20), et une partie inférieure de l'autre de la première chambre de revêtement (12) et de la deuxième chambre de revêtement (16) est dotée de la source de revêtement de TCO (20), de sorte que le traitement de revêtement de TCO soit réalisé sur les deux surfaces de la pièce devant être revêtue, respectivement ;
dans lequel deux dispositifs de détection de pression partielle de vapeur d'eau (14) sont disposés, et les deux dispositifs de détection de pression partielle de vapeur d'eau (14) sont configurés pour détecter respectivement la pression partielle de vapeur d'eau dans la première chambre de revêtement (12) et la deuxième chambre de revêtement (16) pendant le traitement de revêtement de TCO ;
dans lequel le dispositif de nettoyage par gravure au plasma (15) est disposé dans au moins une de la première chambre tampon (11), de la chambre d'isolation (17), et de la deuxième chambre tampon (13), et le dispositif de nettoyage par gravure au plasma (15) est configuré pour réaliser le nettoyage par gravure ionique sur la plaque de support (10) afin que la pression partielle de vapeur d'eau dans la première chambre de revêtement (12) et la deuxième chambre de revêtement (16) ne soit pas supérieure à 5,0×e⁻³ Pa lorsque la pression partielle de vapeur d'eau détectée par le dispositif de détection de pression partielle de vapeur d'eau (14) est supérieure à 5.0×e⁻³ Pa.

10. Appareil de revêtement de TCO (1) selon la revendication 9, dans lequel deux dispositifs de nettoyage par gravure au plasma (15) sont disposés, un dispositif de nettoyage par gravure au plasma (15) est situé au niveau de la partie supérieure de l'une quelconque de la première chambre tampon (11), de la chambre d'isolation (17) et de la deuxième chambre tampon (13), et un autre dispositif de nettoyage par gravure au plasma (15) est situé au niveau de la partie inférieure de l'une quelconque de la première chambre tampon (11), de la chambre d'isolation (17) et de la deuxième chambre tampon (13), de sorte que le nettoyage par gravure ionique soit réalisé sur des surfaces supérieure et inférieure de la plaque de support (10).

11. Appareil de revêtement de TCO (1) selon l'une quelconque des revendications 8 à 10, dans lequel l'appareil de revêtement de TCO (1) comprend en outre une chambre d'alimentation (18) et une chambre de décharge (19), la chambre d'alimentation (18) est disposée en amont de la première chambre tampon (11) pour l'alimentation, et la chambre de décharge (19) est disposée en aval de la deuxième chambre tampon (13) pour la décharge.

12. Appareil de revêtement de TCO (1) selon l'une quelconque des revendications 8 à 11, dans lequel le dispositif de nettoyage par gravure au plasma (15) est sélectionné dans le groupe consistant en un réacteur à cyclotron électronique, un coupleur inductif, un coupleur capacitif, un réacteur à double source plasma, un réacteur à gravure ionique à réaction magnétique améliorée, ou une combinaison de ceux-ci ; ou
le dispositif de détection de pression partielle de vapeur d'eau (14) est sélectionné dans le groupe consistant en un analyseur de gaz résiduel, un analyseur de spectre, ou une combinaison de ceux-ci.

13. Procédé de préparation d'une cellule solaire, comprenant les étapes de :
soumission d'une plaquette de silicium monocristallin à un traitement de texturation de surface et de nettoyage chimique afin d'obtenir une plaquette de silicium monocristallin texturée ; et
formation d'un film de silicium amorphe sur une surface de la plaquette de silicium monocristallin texturée, puis formation d'un film conducteur transparent, et enfin préparation d'une électrode pour obtenir une cellule solaire ;
**caractérisé en ce que** l'étape de formation du film conducteur transparent est réalisée selon le procédé de revêtement de TCO selon l'une quelconque des revendications 1 à 7 ou en utilisant l'appareil de revêtement de TCO (1) selon l'une quelconque des revendications 8 à 12.

14. Procédé de préparation de la cellule solaire selon la revendication 13, dans lequel l'étape de formation du film de silicium amorphe comprend une étape suivante de :
formation de films de silicium amorphe intrinsèque sur des surfaces supérieure et inférieure de la tranche de silicium monocristallin texturée respectivement, puis formation d'un film de silicium amorphe dopé de type p et d'un film de silicium amorphe dopé de type n sur les surfaces supérieure et inférieure respectivement ; ou
l'étape de préparation de l'électrode comprend une étape suivante de :
sérigraphie d'une pâte d'argent sur des surfaces du film conducteur transparent, puis frittage à 170 °C à 200 °C.
